# EUROPEAN PATENT APPLICATION

(11) **EP 2 565 908 A1**
(43) Date of publication of application: **06.03.2013**
(21) Application number: 11774860.8
(22) Date of filing: 19.04.2011
(51) Int. Cl.: H01L 21/205, C23C 16/455

(54) **VAPOR DEPOSITION DEVICE, VAPOR DEPOSITION METHOD, AND SEMICONDUCTOR ELEMENT MANUFACTURING METHOD**

(30) Priority: 28.04.2010 JP 2010103984
(71) Applicant: Sharp Kabushiki Kaisha, Osaka-shi, Osaka 545-8522 (JP)
(72) Inventor: ADACHI, Yusuke, Osaka 545-8522 (JP); SAKAGAMI, Hidekazu, Osaka 545-8522 (JP)
(74) Representative: Hoffmann, Jörg Peter
(86) International application number: PCT/JP2011/059581
(87) International publication number: WO 2011/136077

(57) **Abstract**

In the disclosed vapor deposition method, by using a structure wherein an inner diameter (W1) of a group-V source gas introduction piping (42) is greater than an outer diameter (W2) of a group-III source gas introduction piping (44), and the group-III source gas introduction piping (44) is inserted one-to-one into the interior of the group-V source gas introduction piping (42), the group-III source gas piping (44) is thereby prevented from being cooled by a cooling mechanism, and hardening of metallic materials upon the surface of the wall of the piping is alleviated. It is thus possible to provide a vapor deposition device, a vapor deposition method, and a semiconductor element manufacturing method, which are capable of efficaciously introducing easily hardening metallic materials into a reactor without the metallic materials adhering to a showerhead or a piping, and to carry out efficacious doping.

## Description

### TECHNICAL FIELD

The present invention relates to a vapor deposition device such as vertical showerhead type MOCVD (Metal Organic Chemical Vapor Deposition) or the like, for example, a vapor deposition method and a semiconductor element manufacturing method.

### BACKGROUND ART

In general, a thin film of a group III-V semiconductor crystal of GaAs, InGaP or the like is employed in a device such as a light-emitting diode, a semiconductor laser or the like. In recent years, a nitride crystal represented by InGaN or InGaNAs, referred to as a III-V nitride-based semiconductor crystal, has been particularly watched with interest.

InGaN or InGaNAs referred to as the aforementioned III-V nitride-based semiconductor crystal has a band gap of 0.8 eV to 1.0 eV absent in semiconductor crystals other than the aforementioned III-V nitride-based semiconductor crystal such as InGaP or InGaAs, and hence high-efficiency light emission and photoreceiving become possible.

Further, a technique of varying the band gap with the composition of doped nitride has also been reported, and attention to a high-quality nitride-based semiconductor crystal is paid from various types semiconductor application fields. In particular, expectation has increased in the field of a solar cell to which streamlining is earnestly desired.

In manufacturing of these semiconductor crystals, MOCVD (Metal Organic Chemical Vapor Deposition) growing a compound semiconductor crystal by introducing an organic metal gas such as trimethyl gallium (TMG) or trimethyl aluminum (TMA) and a hydrogen compound gas such as ammonia (NH3), phosphine (PH3) or arsine (AsH3) or a hydrocarbon compound gas such as tertiary butyl arsine (TBAs) into a growth chamber as source gases contributing to film formation is widely known.

MOCVD is a method introducing the aforementioned source gases into the growth chamber along with an inert gas, heating the same and vapor-phase-reacting the same on a prescribed substrate thereby growing a compound semiconductor crystal on the substrate.

In manufacturing of the compound semiconductor crystal employing MOCVD, it is regularly highly required how to ensure a yield and productive capacity to the maximum by suppressing the cost while improving the quality of the growing compound semiconductor crystal. In other words, film forming efficiency indicating how many crystals could be film-formed from source gases is desirably higher. In order to apply the same as an excellent device, the film thickness and the composition ratio are desirably uniform.

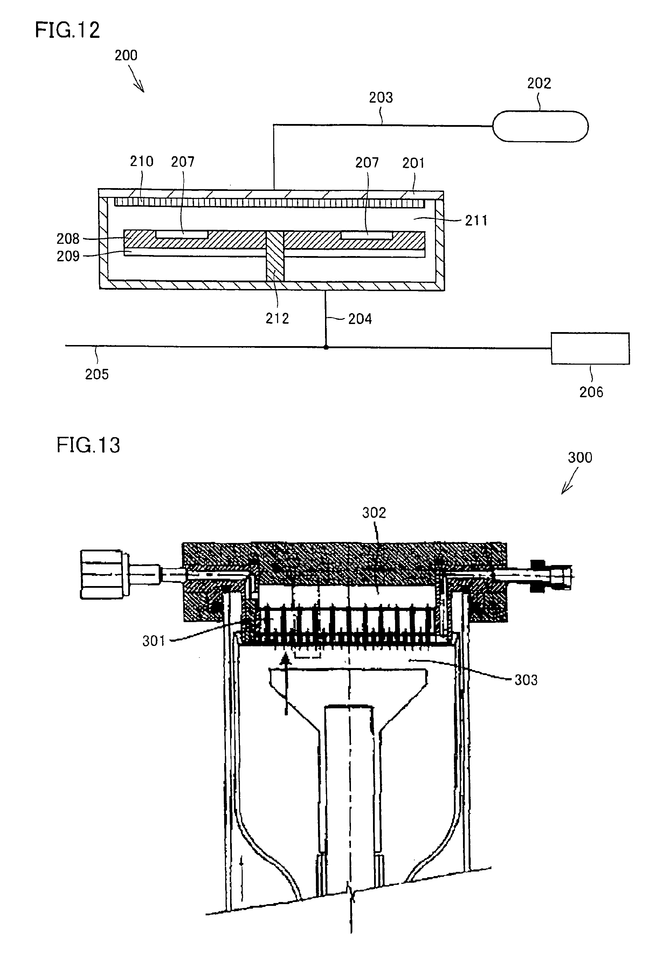

Fig. 12 shows a schematic structure of an example of a conventional vertical showerhead type MOCVD device 200 employed for MOCVD. In MOCVD device 200, a gas pipe 203 for introducing source gases and an inert gas is connected from a gas supply source 202 to a growth chamber 211 in a reactor 201. A shower plate 210 having a plurality of gas discharge ports for introducing the source gases and the inert gas into growth chamber 211 is set as a gas introducing portion in an upper portion of growth chamber 211 in reactor 201.

A rotating shaft 212 rotatable by an unshown actuator is set at the center of a lower portion of growth chamber 211 in reactor 201. A susceptor 208 is mounted on the forward end of rotating shaft 212, to be opposed to shower plate 210. A heater 209 for heating susceptor 208 is mounted on a lower portion of aforementioned susceptor 208.

Further, a gas discharge portion 204 for discharging the gases from growth chamber 211 in reactor 201 is set on a lower portion of reactor 201. Gas discharge portion 204 is connected to an exhaust gas treater 206 for detoxifying the discharged gas through a purge line 205.

In a case of growing a compound semiconductor crystal in vertical showerhead type MOCVD device 200 having the aforementioned structure, one or a plurality of substrates 207 are set on susceptor 208, and susceptor 208 is thereafter rotated by rotation of rotating shaft 212. Then, substrates 207 are heated to a prescribed temperature through susceptor 208 by heating of heater 209. The source gases and the inert gas are introduced from the plurality of gas discharge ports formed in shower plate 210 into growth chamber 211 in reactor 201.

As a method of forming thin films by supplying a plurality of source gases and reacting the same on substrates 207, a method of mixing the plurality of gases in shower plate 210 and injecting the source gases from the gas discharge ports provided in shower plate 210 in a large number to substrates 207 has been adopted in general.

In recent years, a method of providing buffer areas for respective ones of a plurality of supplied gases and supplying the respective source gases from these buffer areas into the growth chamber in separated states through the gas discharge ports of shower plate 210 has been frequently employed in general. This is in order to avoid occurrence of gas phase reaction in the showerhead.

For example, Fig. 13 shows a reaction vessel 300 disclosed in Japanese Patent Laying-Open No. 8-91989 (Fig. 2) (PTL 1). In reaction vessel 300, such a multilayer structure is employed that a buffer area 301 for a group III source gas and a buffer area 302 for a group V source gas are vertically arranged and gas passages are separated from each other so that the respective gases do not get mixed in portions other than a growth chamber 303. In the case of reaction vessel 300, the aforementioned group III source gas discharge ports and group V source gas discharge ports are alternately approximately arranged on a shower plate.

In Japanese Patent Laying-Open 2000-144432 (PTL 2), there is disclosed a structure for preventing prereaction and injecting a mixed gas toward a substrate in a stable state by arranging a nozzle member communicating with a second gas space in a gas injection port communicating with a first gas space.

For the purposes of ensuring uniformity of a film and suppressing adhesion of products to a showerhead, a temperature control mechanism or a cooling mechanism is frequently provided on a gas introducing pipe immediately above the showerhead. For example, a passage in which cooling water flows is provided on a shower surface in the aforementioned PTL 1.

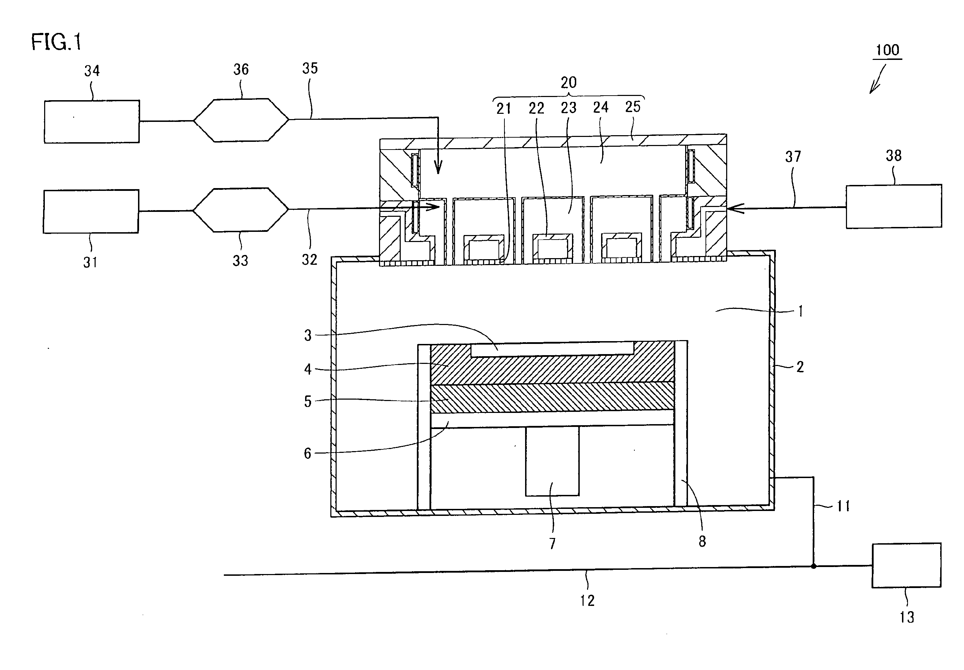

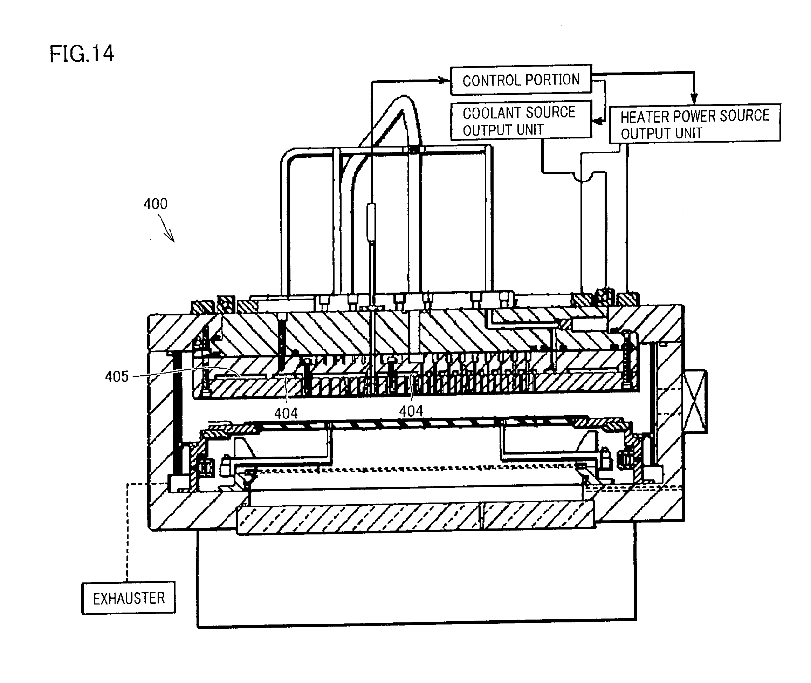

Fig. 14 shows a film forming device 400 disclosed in Japanese Patent Laying-Open No. 2007-273747 (Fig. 1) (PTL 3). In film forming device 400, an annular temperature control chamber 405 is provided on the periphery of a gas passage 404, and a gas in gas passage 404 can be kept at a constant temperature by feeding a coolant or a heating medium into temperature control chamber 405 thereby controlling the temperature in gas passage 404.

As described above, the MOCVD device is a device frequently employed for preparing a compound semiconductor crystal. In order that a semiconductor crystal obtains desired characteristics, a semiconductor may be doped with impurities in preparation. Therefore, various dopant gases may be used for source gases also in the MOCVD device.

At this time, there is such a problem that a partial metallic material such as Cp2Mg (biscyclopentadienyl magnesium) coagulates in a pipe in the showerhead or on a wall surface in the showerhead due to a temperature drop caused by insufficient temperature control. Thus, a problem such as deterioration of material efficiency, clogging of the showerhead, deterioration of controllability of a doping concentration or the like is caused.

With respect to this problem, a method of raising the temperature of a doping gas in advance before introducing the same into a growth chamber is disclosed in relation to an MOCVD device 500 disclosed in Japanese Patent Laying-Open No. 4-11419 (Fig. 1) (PTL 4) shown in FIG. 15, for example.

Plurally present source gases are introduced into a showerhead 507 arranged on an upper portion of a growth chamber 503 storing a susceptor 501 and a substrate 502 through introducing pipes 508a to 508d separate from each other respectively. At this time, a preheater 506 for temperature rising is provided on introducing pipe 508d introducing material hard to decompose. Thus, the material hard to decompose can be heated in advance, and improvement of a doping concentration can be attained. The technique of raising the temperature of the gas in advance in this manner can be conceivably expected as effective also for prevention of coagulation in the pipe or on the wall surface in the showerhead resulting from the aforementioned insufficient temperature.

### CITATION LIST

### PATENT LITERATURE

PTL 1: Japanese Patent Laying-Open No. 8-91989
PTL 2: Japanese Patent Laying-Open No. 2000-144432
PTL 3: Japanese Patent Laying-Open No. 2007-273747
PTL 4: Japanese Patent Laying-Open No. 4-111419

### SUMMARY OF INVENTION

### TECHNICAL PROBLEM

However, the cooling mechanism has been frequently provided on the gas introducing pipe immediately above the showerhead in recent years as described above, and the metallic material is cooled again in the showerhead, particularly in a stage immediately in front of the growth chamber in this case even if the temperature has been raised in advance, to result in problems such as coagulation of the metallic material, deterioration of material efficiency resulting therefrom, clogging of the showerhead, deterioration of controllability of a doping concentration and the like.

The present invention has been proposed in consideration of the aforementioned conventional problems, and an object thereof is to provide a vapor deposition device capable of performing effective doping by effectively introducing a metallic material easy to coagulate into a reactor without making the same adhere to a showerhead or a wall surface of a pipe, a vapor deposition method and a semiconductor element manufacturing method.

### SOLUTION TO PROBLEM

A vapor deposition device according to the present invention is a vapor deposition device supplying a group III source gas and a group V source gas into a growth chamber storing a film-formed substrate through a showerhead type gas supply mechanism in which a group III source gas introducing pipe having a plurality of group III source gas discharge ports and a group V source gas introducing pipe having a plurality of group V source gas discharge ports, individually discharging the gases respectively, are arranged, and mixing the gases with each other in the aforementioned growth chamber for film-forming the aforementioned film-formed substrate, and includes the following structure:

A group V source gas buffer area and a group III source gas buffer area, isolated from each other, introducing the respective ones of the aforementioned group V source gas and the aforementioned group III source gas are stacked and arranged in the aforementioned showerhead type gas supply mechanism, the aforementioned showerhead type gas supply mechanism includes a shower plate in contact with the aforementioned growth chamber, a cooling mechanism for cooling the aforementioned shower plate is provided in the aforementioned showerhead type gas supply mechanism between the aforementioned shower plate and the aforementioned group V source gas buffer area, the inner diameter of the aforementioned group V source gas introducing pipe is greater than the outer diameter of the aforementioned group III source gas introducing pipe, and the aforementioned group III source gas introducing pipe is positioned in the aforementioned group V source gas introducing pipe in a one-to-one manner.

### ADVANTAGEOUS EFFECTS OF INVENTION

According to the present invention, the group V source gas buffer area and the group III source gas buffer area, isolated from each other, filling up the showerhead gas supply mechanism with the respective ones of the aforementioned group V source gas and the group III source gas are stacked so that the group V source gas buffer area is on a gas discharge side.

Thus, the group III source gas and the group V source gas do not get mixed with each other until the same are introduced into the growth chamber and mixed with each other, and form no products in the showerhead. Therefore, such phenomena are prevented that the source gases react with each other in the showerhead and products adhere to the inner portion when the temperature of the group III source gas buffer area is raised with a temperature raising mechanism so that no metallic material coagulates in the showerhead.

As to the positional relation between the group III source gas buffer area and the group V source gas buffer area, the group V source gas buffer area is stacked as the gas discharge side for employing a section adjacent to the cooling mechanism for cooling a shower surface as the group V source gas buffer area, thereby preventing such phenomena that the group III source gas buffer area is cooled by the cooling mechanism and a metallic material introduced into the group III source gas buffer area coagulates in the showerhead.

Also with respect to such a problem that the aforementioned group III source gas introducing pipe and the group V source gas introducing pipe pass through the aforementioned cooling mechanism to introduce the source gases into the growth chamber at the time of gas introduction and hence the metallic material passing through the pipe is cooled by the cooling mechanism to easily coagulate on the wall surface of the pipe, in addition, the group III source gas pipe is prevented from being cooled by the cooling mechanism and coagulation of the metallic material on the pipe wall surface is suppressed by rendering the inner diameter of the group V source gas introducing pipe greater than the outer diameter of the group III source gas introducing pipe and adopting the structure in which the aforementioned group III source gas introducing pipe is inserted into the aforementioned group V source gas introducing pipe in a one-to-one manner.

According to the above effects, a metallic material, easy to coagulate, such as Cp2Mg (biscyclopentadienyl magnesium), for example, can be properly guided into the growth chamber without coagulating the same in the showerhead in the pipe, and effective film formation can be efficiently performed.

Further, the source gas introducing pipes are doubled, and the group III source gas containing a large quantity of carrier gas and the group V source gas containing a small quantity of carrier gas are introduced from the inner pipe having a small passage sectional and from the outer side having a large passage sectional area respectively, whereby loadings of the carrier gases on the whole can be reduced, and the cost can be suppressed.

In this specification, the metallic material easy to coagulate denotes a material such as Cp2Mg, for example, solid at room temperature, and a metallic material kept in a cylinder, exhibiting a small takeout quantity at a time of being introduced by a technique, referred to as bubbling, of passing a carrier gas into an inner portion and taking out part of the material by vapor pressure equilibrium, or coagulating by a slight temperature drop even if the same can be taken out.

### BRIEF DESCRIPTION OF DRAWINGS

Fig. 1 is a schematic block sectional view of a vertical showerhead type vapor deposition device which is an example of a vapor deposition device in an embodiment.
Fig. 2 is a schematic sectional view showing the structures of a shower plate and a cooling mechanism.
Fig. 3 is a plan view showing an example of arrangement of gas discharge ports prepared on the shower plate.
Fig. 4 is a plan view showing another example of arrangement of gas discharge ports prepared on the shower plate.
Fig. 5 is a plan view showing still another example of arrangement of gas discharge ports prepared on the shower plate.
Fig. 6 is a schematic sectional view showing the structure of a group III source gas buffer area.
Fig. 7 is a sectional view showing a structure at a time of assembling the showerhead.
Fig. 8 is a diagram showing another positional relation between group V source gas discharge ports and group III source gas discharge ports.
Fig. 9 is a diagram showing still another positional relation between the group V source gas discharge ports and the group III source gas discharge ports.
Fig. 10 is a perspective view showing the structure of a group V source gas outer reflux passage.
Fig. 11 is a sectional view showing an example of a semiconductor element having a film formed on a film-formed substrate by metal organic chemical vapor deposition by employing the vapor deposition device in this embodiment.
Fig. 12 is a schematic block sectional view of an example of a conventional vertical showerhead type vapor deposition device employed for vapor deposition.
Fig. 13 is a schematic block sectional view showing an example of a vertical showerhead type vapor deposition device, employed for vapor deposition, separating a plurality of source gases from each other by buffer areas and separately introducing the same into a growth chamber.
Fig. 14 is a schematic block sectional view of an example of a vertical showerhead type vapor deposition device, employed for vapor deposition, having a mechanism of keeping the temperature in a pipe at a constant level.

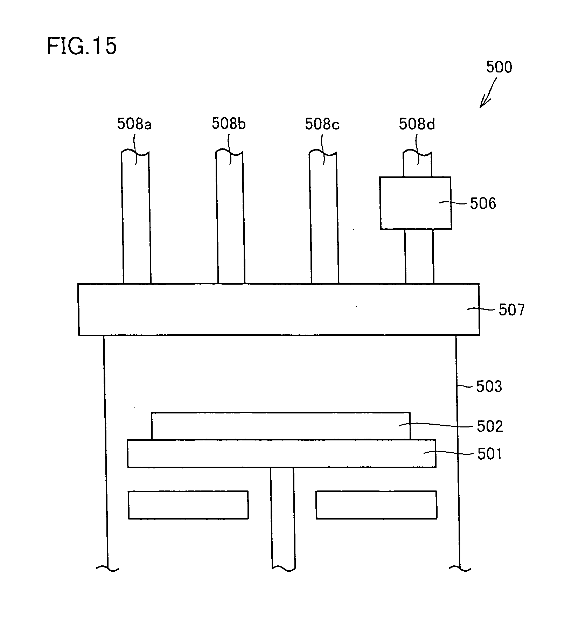

Fig. 15 is a schematic block sectional view of an example of a vertical showerhead type vapor deposition device, employed for vapor deposition, having a mechanism of raising the temperatures of source gases in advance.

### DESCRIPTION OF EMBODIMENTS

When describing one embodiment of the present invention on the basis of Figs. 1 to 11, the same is as follows. In the drawings of this embodiment, it is assumed that the same reference signs denote the same portions or corresponding portions.

When numbers, quantities and the like are mentioned in the embodiment described below, the range of the present invention is not necessarily restricted to the numbers, the quantities and the like, except a case where description is particularly made. The same reference numerals are assigned to the same components and corresponding components, and there is a case where redundant description is not repeated.

### (Basic Structure of Device)

Fig. 1 shows an example of a schematic structure of a vertical showerhead type MOCVD device 100 which is an example of an MOCVD (Metal Organic Chemical Vapor Deposition) device as a vapor deposition device in an embodiment based on the present invention.

As shown in Fig. 1, MOCVD device 100 according to this embodiment includes a reactor 2 having a growth chamber 1 which is a hollow portion, a susceptor 4 receiving a film-formed substrate 3, and a showerhead type gas supply mechanism (hereinafter simply referred to as a showerhead) 20 opposed to aforementioned susceptor 4 and having a shower plate 21 in contact with growth chamber 1 on the bottom surface.

A heater 5 heating film-formed substrate 3 and a support 6 are provided on a lower side of aforementioned susceptor 4, and a rotating shaft 7 mounted on support 6 rotates by an unshown actuator or the like, so that aforementioned susceptor 4 rotates while keeping a state where the upper surface (surface on the side of shower plate 21) of susceptor 4 is parallel to opposed shower plate 21.

On the peripheries of aforementioned susceptor 4, heater 5, support 6 and rotating shaft 7, a covering plate 8 which is a heater cover is provided to surround susceptor 4, heater 5, support 5 and rotating shaft 7.

Further, MOCVD device 100 has a gas discharge portion 11 for discharging gases from growth chamber 1, a purge line 12 connected to gas discharge portion 12, and an exhaust gas treater 13 connected to purge line 12.

Thus, gases introduced into growth chamber 1 are discharged from growth chamber 1 through gas discharge portion 11, and the discharged gases are introduced into exhaust gas treater 13 through purge line 12, to be detoxified in exhaust gas treater 13.

### (Basic Structure of Showerhead 20)

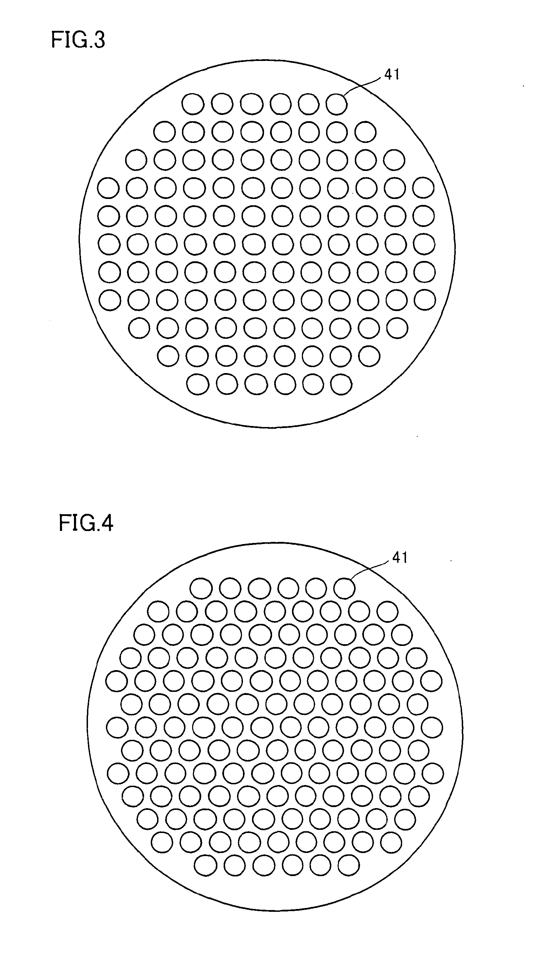

The structure of showerhead 20 is now described with reference to Figs. 1 and 4. Showerhead 20 is constituted of shower plate 21, a cooling mechanism 22, a group V source gas buffer area 23, a group III source gas buffer area 24 and a temperature-raising mechanism 25 in order from the side of growth chamber 1.

A group III source gas containing a group III element supplied from a group III source gas supply source 34 is introduced into group III source gas buffer area 24 through a group III source gas pipe 35 and a mass flow controller 36. Similarly, a group V source gas containing a group V element supplied from a group V source gas supply source 31 is introduced into group V source gas buffer area 23 through a group V source gas pipe 32 and a mass flow controller 33. Aforementioned mass flow controllers 33 and 36 are to be controlled by an unshown control portion.

In this embodiment, at least one type of a gas containing a group III element such as Ga (gallium), Al (aluminum) or In (indium), for example, such as an organic metal gas such as trimethyl gallium (TMG) or trimethyl aluminum (TMA), for example, can be employed as the group III source gas. At this time, it is assumed that a dopant gas such as biscyclopentadienyl magnesium (Cp2Mg), monosilane (SiH4) or dimethyl zinc (DMZn) can also be contained in the group III source gas.

Further, at least one type of a gas containing a group V element such as N (nitrogen), P (phosphorus) or As (arsenic), for example, such as a hydrogen compound gas such as ammonia (NH₃), phosphine (PH₃) or arsine (AsH₃), for example, or a hydrocarbon compound gas such as tertiary butyl arsine (TBAs) can be employed as the group V source gas.

Cold water is to be supplied to cooling mechanism 22 from a water cooler 38 through a cold water-system pipe 37. While cooling mechanism 22 is to supply cooling water in this embodiment, the supplied substance is not necessarily restricted to the water, but it is possible to employ a coolant prepared from another liquid and a gas.

Temperature-raising mechanism 25 has a structure obtained by spreading a silicon rubber heater all over the upper surface of group III source gas buffer area 24, and is energized by an unshown power supply system for raising the temperature. While the heater is employed for temperature-raising mechanism 25 in this embodiment, the temperature of group III source gas buffer area 24 may be raised by providing a passage on group III gas buffer area 24 similarly to cooling mechanism 22 and feeding a heat medium from an external device in place of the coolant.

### (Structural Description of Inner Portion of Showerhead 20)

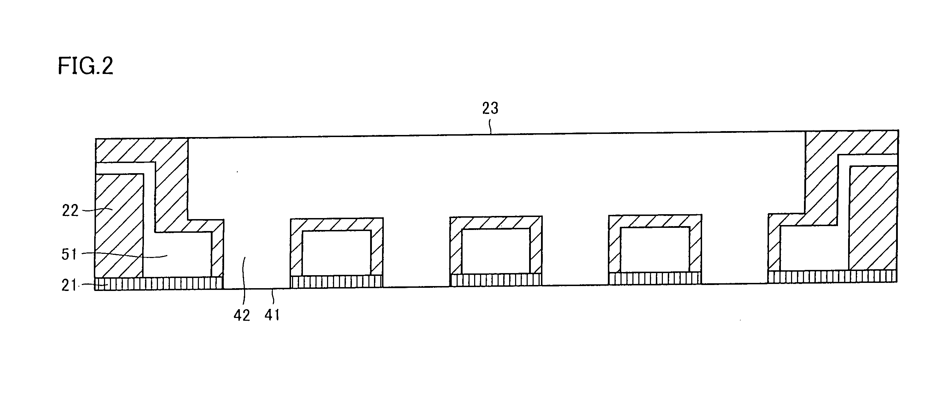

Fig. 2 shows a schematic diagram of the structures of shower plate 21 and cooling mechanism 22. A plurality of group V source gas discharge ports 41 are provided on shower plate 21, and lead up to group V source gas buffer area 23 provided above aforementioned shower plate 21 through group V source gas introducing pipes 42.

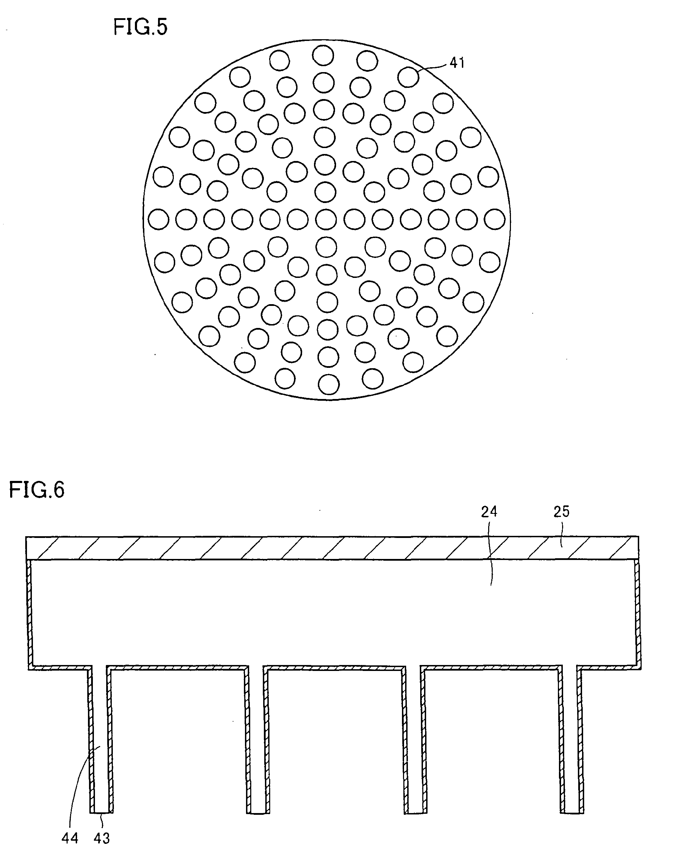

The directions of arrangement of plurally provided group V source gas discharge ports 41 and group V source gas introducing pipes 42 are horizontal and vertical directions, i.e., in the form of a lattice, as shown in Fig. 3. However, this lattice is not restricted to a tetragonal lattice, but may be a rhomboidal lattice, as shown in Fig. 4. Further, the same may be radially provided, as shown in Fig. 5. In addition, the sections of group V source gas introducing pipes 42 and group V source gas discharge ports 41 are not necessarily restricted to circular shapes, but may be in the form of rectangular pipes, elliptic pipes, or other sections.

Cooling mechanism 22 is provided immediately above shower plate 21 on the peripheries of group V source gas introducing pipes 42. Cooling mechanism 22 has a coolant supply passage 51, so that cooling water flows into coolant supply passage 51 from a side portion of showerhead 20 and flows out from an opposite side portion of showerhead 20, for example. Shower plate 21 is cooled to not more than a constant temperature by aforementioned cooling mechanism 22.

Fig. 6 shows a schematic sectional view expressing the structure of group III source gas buffer area 24. A plurality of group III source gas introducing pipes 44 extend from group III source gas buffer area 24, and the group III source gas is introduced from group III source gas discharge ports 43 provided on forward ends into growth chamber 1.

The directions of arrangement of plurally provided group V source gas discharge ports 41 and group III source gas introducing pipes 44 are horizontal and vertical directions, i.e., in the form of a lattice correspondingly to the arrangement of group V source gas discharge ports 41 shown in Fig. 3. However, this lattice is not restricted to a tetragonal lattice, but may be a rhomboidal lattice, correspondingly to the arrangement of group V source gas discharge ports 41 shown in Fig. 4. Further, the same may be radially provided, correspondingly to the arrangement of group V source gas discharge ports 41 shown in Fig. 5. In addition, the sections of group III source gas introducing pipes 44 and group III source gas discharge ports 43 are not necessarily restricted to circular shapes, but may be in the form of rectangular pipes, elliptic pipes, or other sections.

Temperature-raising mechanism 25 is provided on an upper portion of group III source gas buffer area 24, to raise the temperature of group III source gas buffer area 24 to at least ordinary temperature from the upper surface.

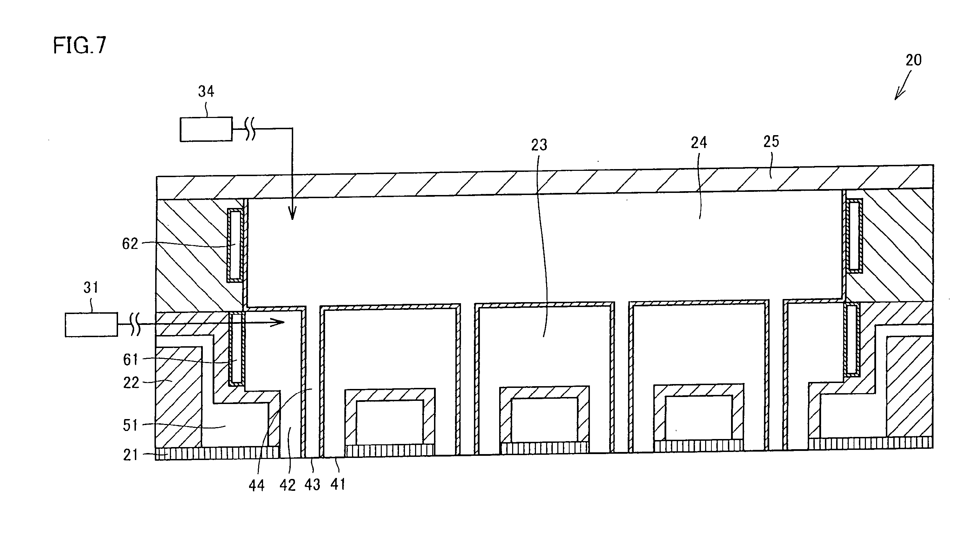

Fig. 7 shows a sectional view at a time of assembling showerhead 20. Cooling mechanism 22 and group III source gas buffer area 24 are fastened to each other on outer peripheral portions, to constitute showerhead 20. At this time, group V source gas buffer area 23 is defined by a concave space on the upper surface side of cooling mechanism 22, the bottom surface of group III source gas buffer area 24 and a constituted space.

Cooling mechanism 22 and group III source gas buffer area 24 are fastened to each other by using an unshown O-ring, a gasket and the like, whereby the group V source gas supplied to group V source gas buffer area 23 does not leak out to an external portion.

The inner diameter (W1) of aforementioned group V source gas introducing pipes 42 is greater than the outer diameter (W2) of aforementioned group III source gas introducing pipes 44, and group III source gas introducing pipes 44 are inserted into group V source gas introducing pipes 42 in a one-to-one manner. Thus, spaces are formed between group III source gas introducing pipes 44 and cooling mechanism 22, to prevent the group III source gas from being cooled.

In addition, the passage of the group V source gas becomes larger as compared with the passage of the group III source gas when employing this pipe structure (assuming that the radio between the diameters of group III source gas introducing pipes 42 and group V source gas introducing pipes 42 is 1:2, for example, the area ratio between the passages of the group III source gas and the group V source gas becomes 1:3). Therefore, the flow rate of a required carrier gas can be rendered small.

It is known that, in a case of performing film formation in an MOCVD device in general, a ratio, referred to as a V/III ratio, between mole numbers of a group V raw material and a group III raw material exerts a remarkable influence on film quality. In order to form a high-quality film, this value frequently becomes at least 500.

If the group V raw material is fed in a flow rate 500 times that of the group III raw material in practice, however, the group V material whose flow velocity is high reaches film-formed substrate 3 in advance, diffuses onto film-formed substrate 3 and inhibits arrival of the group III gas whose flow velocity is low such that it becomes difficult to control the V/III ratio in reaction. Therefore, the V/III ratio must be controlled to be constant by feeding a carrier gas irrelevant to the reaction to the group III raw material side in a large quantity and equalizing the gas flow rates to each other.

At this time, an introducing passage for the group V source gas having the large flow rate enlarges and the flow rate of the group V source gas necessary for obtaining a certain flow velocity inevitably increases in the pipe structure of this embodiment, whereby the necessary carrier gas flow rate can be reduced as compared with a case where the magnitudes of the introducing passages of the group III·group V source gases are equal to each other.

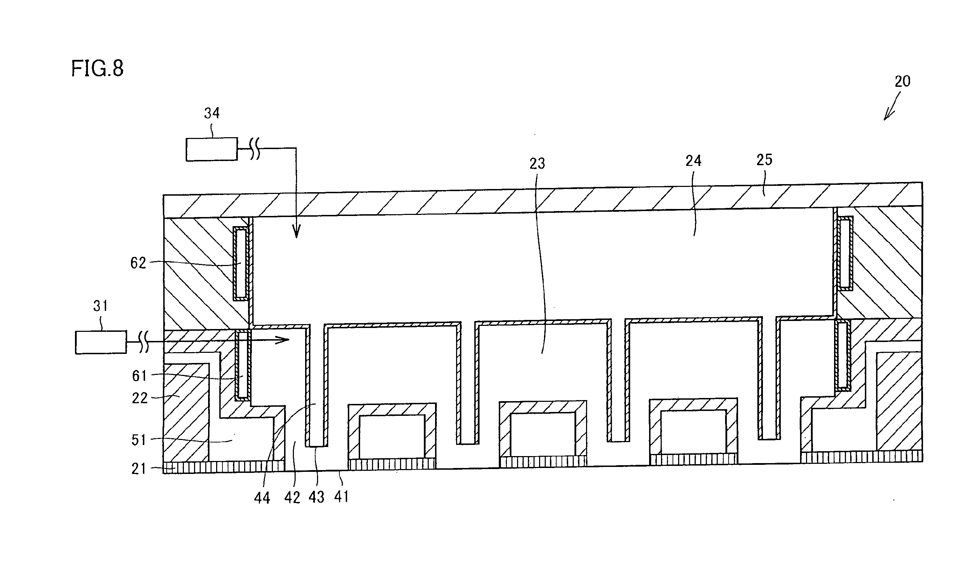

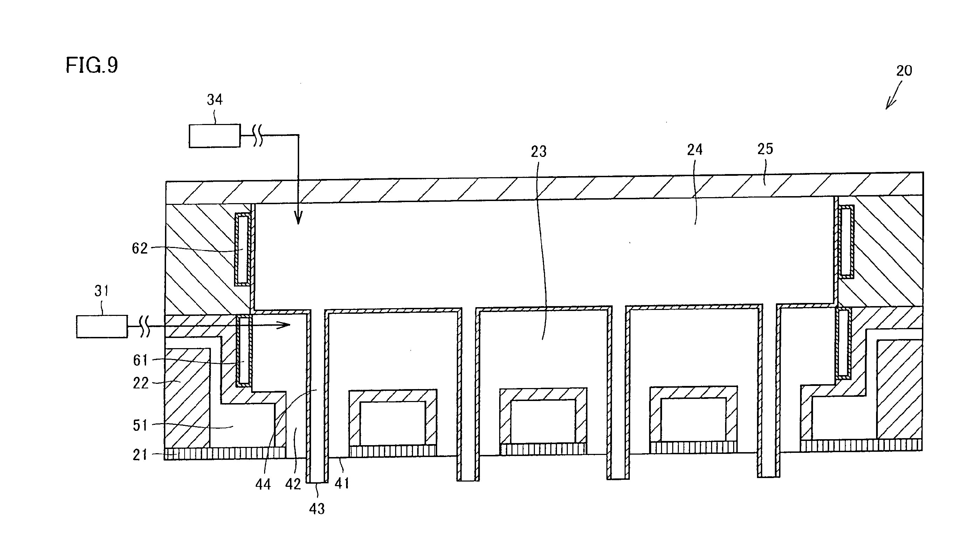

While group V source gas discharge ports 41 and group III source gas discharge ports 43 are provided to be positioned on the same plane in this embodiment as shown in Fig. 7, the positional relation between group V source gas discharge ports 41 and group III source gas discharge ports 43 may not necessarily be on the same plane, but either V source gas discharge ports 41 or group III source gas discharge ports 43 may be present on positions protruding with respect to either group III source gas discharge ports 43 or V source gas discharge ports 41, as shown in Figs. 8 and 9.

Group V source gas buffer area 23 includes a group V source gas outer reflux passage 61 on a buffer area sidewall portion, in order to uniformly guide the group V source gas supplied from a peripheral portion, for example, of showerhead 20 into group V source gas introducing pipes 42.

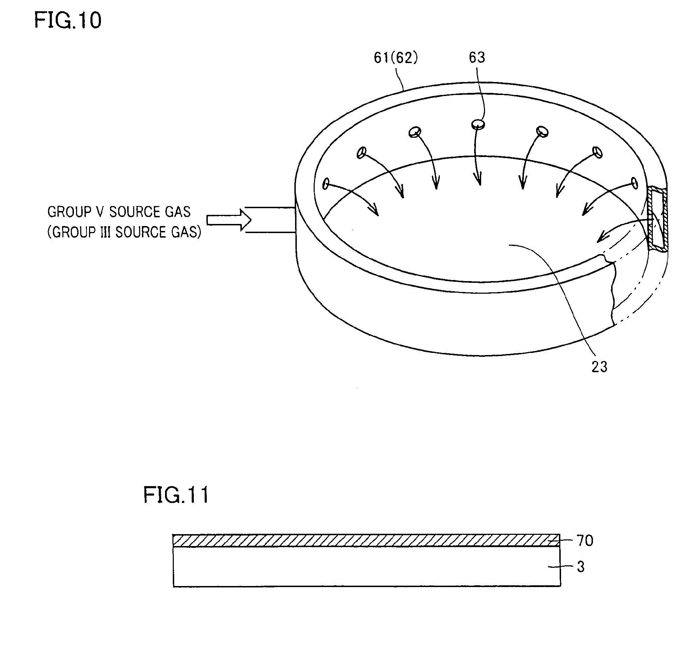

On the other hand, group III source gas buffer area 24 similarly includes a group III source gas outer reflux passage 62 on a buffer area sidewall portion, in order to uniformly guide the source gas supplied from the peripheral portion, for example, of showerhead 20. Fig. 10 is a perspective view of group V source gas outer reflux passage 61 (group III source gas outer reflux passage 62 is also identical in structure and hence description is omitted).

For example, the group V source gas supplied from a lateral direction of group V source gas outer reflux passage 61 is supplied into group V source gas buffer area 23 uniformly in the circumferential direction, through a plurality of group V source gas supply ports 63 uniformly arranged on an inner peripheral side of group V source gas outer reflux passage 61. The group V source gas in group V source gas buffer area 23 is supplied from group V source gas discharge ports 41 into growth chamber 1, through aforementioned plurality of group V source gas introducing pipes 42.

### (Semiconductor Element Manufacturing Method employing MOCVD Device 100)

A semiconductor element manufacturing method based on vapor deposition employing MOCVD device (vapor deposition device) 100 is now described.

At least one type of a gas containing a group III element such as Ga (gallium) or Al (aluminum), for example, such as an organic metal gas such as trimethyl gallium (TMG) or trimethyl aluminum (TMA), for example, is introduced into MOCVD device 100 in this embodiment as the group III source gas.

Further, at least one type of a gas containing a group V element such as N (nitrogen), P (phosphorus) or As (arsenic), for example, such as a hydrogen compound gas such as ammonia (NH₃), phosphine (PH₃) or arsine (AsH₃), for example, or a hydrocarbon compound gas such as tertiary butyl arsine (TBAs) is introduced into MOCVD device 100 in this embodiment as the group V source gas.

At this time, it is assumed that a dopant gas, easy to coagulate, such as biscyclopentadienyl magnesium (Cp2Mg), for example, is also contained in the group III source gas.

The group III source gas introduced into MOCVD device 100 is introduced from group III source gas buffer area 24 into growth chamber 1 through group III source gas introducing pipes 44, while the group V source gas is introduced from group V source gas buffer area 23 into growth chamber 1 through group V source gas introducing pipes 42.

The group III source gas and the group V source gas introduced into growth chamber 1 are sprayed onto film-formed substrate 3 set on susceptor 4 in growth chamber 1. The temperature of film-formed substrate 3 has been raised to a prescribed temperature by heater 5 provided under susceptor 4, the source gases sprayed onto film-formed substrate 3 are decomposed by this heat to react, and a desired film 70 is formed on film-formed substrate 3, as shown in Fig. 11.

Source gases having not contributed to the reaction are discharged from growth chamber 1 through gas discharge portion 11, and the discharged gases are introduced into exhaust gas treater 13, to be detoxified in exhaust gas treater 13. A semiconductor element of a prescribed structure is formed on film-formed substrate 3 which is a semiconductor substrate by repeatedly carrying out the aforementioned steps.

### (Functions·Effects)

Thus, according to MOCVD device 100 in this embodiment, the structure in which group V source gas buffer area 23 and group III source gas buffer area 24, isolated from each other, filling the respective ones of the group V source gas and the group III source gas are stacked with each other so that group V source gas buffer area 23 serves as a gas discharge side is employed for the shower head 20.

Thus, the group III source gas and the group V source gas do not get mixed with each other until the same are introduced into growth chamber 1 and mixed with each other, and do not form products in showerhead 20. When the temperature of group III source gas buffer area 24 is raised by the temperature-raising mechanism 25 so that no metallic material coagulates in showerhead 20, therefore, such phenomena are prevented that the source gases react with each other in the showerhead and products adhere to the inner portion.

As to the positional relation between group III source gas buffer area 24 and group V source gas buffer area 23, group V source gas buffer area 23 is stacked as the gas discharge side for employing a section adjacent to cooling mechanism 22 for cooling a shower surface of shower plate 21 as group V source gas buffer area 23, thereby preventing such phenomena that group III source gas buffer area 24 is cooled by cooling mechanism 22 and a metallic material introduced into group III source gas buffer area 24 coagulates in showerhead 20.

Also with respect to such a problem that aforementioned group III source gas introducing pipes 44 and group V source gas introducing pipes 42 pass through aforementioned cooling mechanism 22 to introduce the source gases into growth chamber 1 at the time of gas introduction and hence the metallic material passing through the pipes is cooled by cooling mechanism 22 to easily coagulate on the wall surfaces of the pipes, in addition, group III source gas pipes 44 are prevented from being cooled by the cooling mechanism and coagulation of the metallic material onto the pipe wall surfaces is suppressed by rendering the inner diameter (W1) of group V source gas introducing pipes 42 greater than the outer diameter (W2) of group III source gas introducing pipes 44 and adopting the structure in which aforementioned group III source gas introducing pipes 44 are inserted into aforementioned group V source gas introducing pipes 42 in a one-to-one manner.

According to the above effects, a metallic material, easy to coagulate, such as Cp2Mg (biscyclopentadienyl magnesium), for example, can be properly guided into the growth chamber without coagulating the same in the showerhead·in the pipes, and effective film formation can be efficiently performed.

Further, the source gas introducing pipes are doubled so that the group III source gas containing a large quantity of carrier gas and the group V source gas containing a small quantity of carrier gas are introduced from the inner pipe having a small passage sectional and from the outer side having a large passage sectional area respectively, whereby loadings of the carrier gases on the whole can be reduced, and the cost can be suppressed.

While the embodiment of the present invention has been described, the embodiment disclosed this time must be considered as illustrative in all points and not restrictive. The range of the present invention is shown by the scope of claims for patent, and it is intended that all modifications within the meaning and range equivalent to the scope of claims for patent are included.

### INDUSTRIAL APPLICABILITY

The present invention can be utilized for a vapor deposition device such as a vertical MOCVD device employing a metallic material easy to coagulate and a material hard to decompose as raw materials and a semiconductor element manufacturing method employing the same.

### REFERENCE SIGNS LIST

1 growth chamber, 2 reactor, 3 film-formed substrate, 4 susceptor, 5 heater, 6 support, 7 rotating shaft, 8 covering plate, 11 gas discharge portion, 12 purge line, 13 exhaust gas treater, 20 showerhead, 21 shower plate, 22 cooling mechanism, 23 group V source gas buffer area, 24 group III source gas buffer area, 25 temperature-raising mechanism, 31 group V source gas supply source, 32 group V source gas pipe, 33 mass flow controller, 34 group III source gas supply source, 35 group III source gas pipe, 36 mass flow controller, 37 water-cooled-system pipe, 38 water cooler, 41 group V source gas discharge port, 42 group V source gas introducing pipe, 43 group III source gas discharge port, 44 group III source gas introducing pipe, 51 coolant supply passage, 61 group V source gas outer reflux passage, 62 group III source gas outer reflux passage, 63 group V source gas supply port, 70 thin film.

## Claims

1. A vapor deposition device supplying a group III source gas and a group V source gas into a growth chamber (1) storing a film-formed substrate (3) through a showerhead type gas supply mechanism (20) in which a group III source gas introducing pipe (44) having a plurality of group III source gas discharge ports (43) and a group V source gas introducing pipe (42) having a plurality of group V source gas discharge ports (41), individually discharging the gases respectively, are arranged, and mixing the gases with each other in said growth chamber (1) for film-forming said film-formed substrate (3), wherein
a group V source gas buffer area (23) and a group III source gas buffer area (24), isolated from each other, introducing the respective ones of said group V source gas and said group III source gas are stacked and arranged in said showerhead type gas supply mechanism (20),
said showerhead type gas supply mechanism (20) includes a shower plate (21) in contact with said growth chamber (1),
a cooling mechanism (22) for cooling said shower plate (21) is provided in said showerhead type gas supply mechanism (20) between said shower plate (21) and said group V source gas buffer area (23), and
the inner diameter (W1) of said group V source gas introducing pipe (42) is greater than the outer diameter (W2) of said group III source gas introducing pipe (44), and said group III source gas introducing pipe (44) is positioned in said group V source gas introducing pipe (42) in a one-to-one manner.

2. The vapor deposition device according to claim 1, wherein
a plurality of said group III source gas introducing pipes (44) for introducing said group III source gas from said group III source gas buffer area (23) into said growth chamber (1) are provided in said group III source gas buffer area (23) while passing through said group V source gas buffer area (23) and said cooling mechanism (22).

3. The vapor deposition device according to claim 1, wherein
a plurality of said group V source gas introducing pipes (42) for introducing said group V source gas from said group V source gas buffer area (23) into said growth chamber (1) are provided in said group V source gas buffer area (23) while passing through said cooling chamber 22.

4. The vapor deposition device according to claim 1, further comprising a mechanism for raising or keeping the temperature of said group III source gas buffer area (23).

5. The vapor deposition device according to claim 1, wherein
said group III source gas contains at least either a metallic material or a dopant gas.

6. A vapor deposition method including a step of forming a film on a film-formed substrate (3) by employing metal organic chemical vapor deposition by employing a vapor deposition device, wherein
said vapor deposition device
is a vapor deposition device supplying a group III source gas and a group V source gas into a growth chamber (1) storing the film-formed substrate (3) through a showerhead type gas supply mechanism (20) in which a group III source gas introducing pipe (44) having a plurality of group III source gas discharge ports (43) and a group V source gas introducing pipe (42) having a plurality of group V source gas discharge ports (41), individually discharging the gases respectively, are arranged, and mixing the gases with each other in said growth chamber (1) for film-forming said film-formed substrate (3),
a group V source gas buffer area (23) and a group III source gas buffer area (24), isolated from each other, introducing the respective ones of said group V source gas and said group III source gas are stacked and arranged in said showerhead type gas supply mechanism (20),
said showerhead type gas supply mechanism (20) includes a shower plate (21) in contact with said growth chamber (1),
a cooling mechanism (22) for cooling said shower plate (21) is provided in said showerhead type gas supply mechanism (20) between said shower plate (21) and said group V source gas buffer area (23), and
the inner diameter (W1) of said group V source gas introducing pipe (42) is greater than the outer diameter (W2) of said group III source gas introducing pipe (44), and said group III source gas introducing pipe (44) is positioned in said group V source gas introducing pipe (42) in a one-to-one manner.

7. A semiconductor element manufacturing method including a step of forming a film on a film-formed substrate (3) by employing metal organic chemical vapor deposition by employing a vapor deposition device, wherein
said vapor deposition device
is a vapor deposition device supplying a group III source gas and a group V source gas into a growth chamber (1) storing the film-formed substrate (3) through a showerhead type gas supply mechanism (20) in which a group III source gas introducing pipe (44) having a plurality of group III source gas discharge ports (43) and a group V source gas introducing pipe (42) having a plurality of group V source gas discharge ports (41), individually discharging the gases respectively, are arranged, and mixing the gases with each other in said growth chamber (1) for film-forming said film-formed substrate (3),
a group V source gas buffer area (23) and a group III source gas buffer area (24), isolated from each other, introducing the respective ones of said group V source gas and said group III source gas are stacked and arranged in said showerhead type gas supply mechanism (20),
said showerhead type gas supply mechanism (20) includes a shower plate (21) in contact with said growth chamber (1),
a cooling mechanism (22) for cooling said shower plate (21) is provided in said showerhead type gas supply mechanism (20) between said shower plate (21) and said group V source gas buffer area (23), and
the inner diameter (W1) of said group V source gas introducing pipe (42) is greater than the outer diameter (W2) of said group III source gas introducing pipe (44), and said group III source gas introducing pipe (44) is positioned in said group V source gas introducing pipe (42) in a one-to-one manner.
